(19) Europäisches Patentamt / European Patent Office / Office européen des brevets

(11) **EP 3 131 372 A1**

(12) **EUROPEAN PATENT APPLICATION**

(43) Date of publication:
**15.02.2017 Bulletin 2017/07**

(51) Int Cl.:
**H05K 1/11** *(2006.01)*     **H05K 1/18** *(2006.01)*
**H05K 3/34** *(2006.01)*

(21) Application number: **16182516.1**

(22) Date of filing: **03.08.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **10.08.2015 IT UB20153051**

(71) Applicants:
• **OSRAM GmbH**
**80807 München (DE)**
• **OSRAM S.P.A. - SOCIETA' RIUNITE OSRAM EDISON CLERICI**
**20126 Milano (IT)**
Designated Contracting States:
**IT**

(72) Inventors:
• **SCORDINO, Alessandro**
**I-30031 Dolo (Venezia) (IT)**
• **GROSSO, Davide**
**I-31050 Ponzano Veneto (Treviso) (IT)**

(74) Representative: **Bosotti, Luciano**
**Buzzi, Notaro & Antonielli d'Oulx S.r.l.**
**Via Maria Vittoria, 18**
**10123 Torino (IT)**

(54) **A SUBSTRATE FOR MOUNTING LIGHT RADIATION SOURCES AND CORRESPONDING METHOD**

(57)     A substrate (10) for mounting electrically-powered light radiation sources, e.g. LED sources, includes a base layer (12) of electrically-insulating material, such as PET, and a contact layer (141, 142) of electrically conductive material, e.g. copper. The contact layer includes a mounting area for a light radiation source having opposed anode and cathode terminals, including two portions (141, 142) with a gap (143) therebetween. Therefore, the light radiation source may be mounted bridge-like across gap (143), with anode and cathode terminals soldered to respective soldering surfaces (S1, S2) provided in the one (141) and the other (142) of said two portions (141, 142) of the mounting area. The latter portions include respective solder flow blocking formations including fork-shaped apertures (161, 162) in contact layer (141, 142) leaving base layer (12) uncovered. The fork-shaped apertures (161, 162) have a web portion (1610, 1620) and prongs (1612, 1622) extending from web portion (1610, 1620) towards said soldering surfaces (S1, S2).

FIG. 3

**Description**

Technical Field

The present description relates to lighting devices.

One or more embodiments may refer to substrates adapted to be used for the mounting of electrically-powered light radiation sources, e.g. solid state light radiation sources, such as LED sources.

Technological Background

Various solutions of lighting devices employ e.g. flexible substrates, which include a base layer of an electrically insulating material, whereon there is applied a contact layer of electrically conductive material (e.g. copper) adapted to make electrical contact (for power supply, control, etc.) with the light radiation sources mounted on the substrate.

As a base layer for said substrates a polymer material may be used, such as polyethylenterephthalate (PET).

Such materials may undergo thermal shrinkage when they are exposed to temperatures such as may appear when light radiation sources such as LED sources are mounted on the substrate (for example via soldering, e.g. reflow soldering).

The material shrinkage caused by said thermal cycles may depend on various factors, such as e.g. the manufacturing process of the foil material, and may be quantified by a shrinkage factor which is expressed as a percentage, $\Delta s\%$.

The shrinkage may be absent (or at least negligible) if the base layer of the electrically insulating material is covered by a layer of electrically conductive material, e.g. copper, having an appropriate thickness.

Moreover, e.g. during the mounting of LED sources via reflow soldering, the surface tension of the solder paste, if not contrasted, may cause a reduction of the electrical distance between two not-equipotential points (e.g. the anode and cathode terminals of the LED), posing the risk of originating, in the worst of cases, an undesirable solder bridge.

At least in principle, such drawbacks may be avoided by resorting to a substrate implemented as a rigid board (e.g. a Printed Circuit Board, PCB). This solution, however, is not compatible with manufacturing processes (e.g. a reel-to-reel process) which are employed for the manufacture of lighting devices having the shape of elongated (e.g. flexible) LED modules, and which therefore make use of equally flexible substrates of materials such as PET, whereon light radiation sources are mounted via soldering processes, e.g. with low-melt soldering pastes.

Object and Summary

One or more embodiments aim at solving the previously outlined problems.

According to one or more embodiments, said object may be achieved thanks to a substrate having the features specifically set forth in the claims that follow.

One or more embodiments may also concern a corresponding method.

The claims are an integral part of the technical teaching provided herein with reference to the embodiments.

One or more embodiments may envisage a possible coordination of the material properties of the flexible substrate, e.g. as a function of the shrinkage factor of the base material (e.g. PET), and of the substrate geometry, e.g. the geometry of the contact terminals of the light radiation sources.

One or more embodiments may achieve one or more of the following advantages:

- High speed production process,
- Possibility of a continuous production,
- Solder stability of the light radiation sources (e.g. LED sources),
- Assembling flexibility,
- Possibility of using multifunctional fixing structures, and
- Non-visible fixing structure.

Brief Description of the Figures

One or more embodiments will now be described, by way of non-limiting example only, with reference to the annexed Figures, wherein:

- Figure 1 is a plan view of a substrate according to one or more embodiments,
- Figure 2 schematically shows the mounting of a light radiation source onto the substrate of Figure 1;
- Figure 3 shows the surfaces destined to the mounting of such a light radiation source onto the substrate of Figure 1; and
- Figure 4 exemplifies possible shape features of one or more embodiments.

Detailed Description

In the following description, numerous specific details are given to provide a thorough understanding of exemplary embodiments. One or more embodiments may be practiced without one or several specific details, or with other methods, components, materials, etc. In other instances, well-known structures, materials, or operations are not shown or described in detail to avoid obscuring various aspects of the embodiments.

Reference throughout this specification to "one embodiment" or "an embodiment" means that a particular feature, structure, or characteristic described in connection with the embodiment is included in at least one embodiment. Thus, the possible appearances of the phrases "in one embodiment" or "in an embodiment" in various places throughout this specification are not necessarily all referring to the same embodiment. Furthermore, particular features, structures, or characteristics may be combined in any suitable manner in one or more embodiments.

The headings provided herein are for convenience only, and therefore do not interpret the extent of protection or the scope of the embodiments.

In the Figures, reference 10 denotes a substrate which may be used for the mounting of electrically-powered light radiation sources, such as solid state sources, e.g. LED sources.

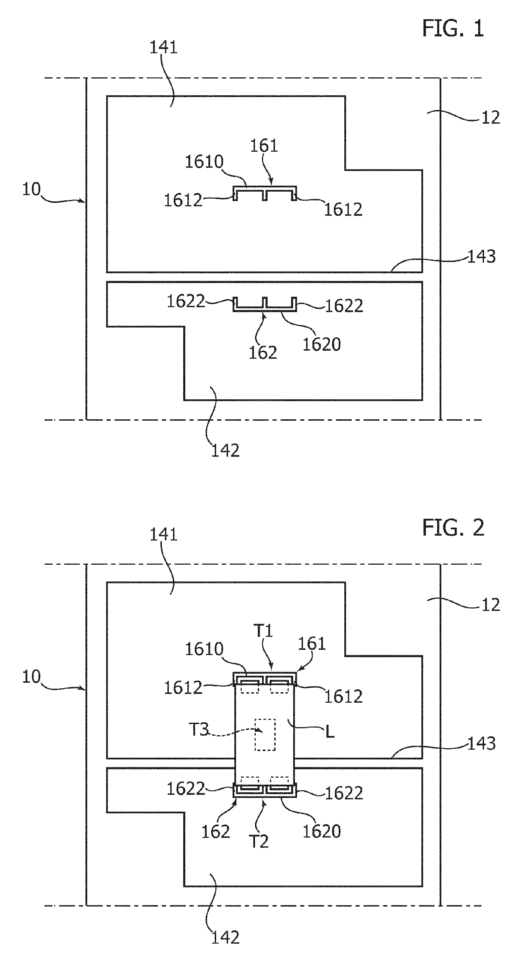

For simplicity of description, Figures 1 to 4 refer to the possible use of a substrate 10 for mounting one light radiation source L.

In one or more embodiments, substrate 10 may have the shape of a ribbon-like, e.g. flexible, substrate having indefinite length, which may be used for mounting a plurality of light radiation sources L. For the sake of simplicity, the Figures show a portion or section of the substrate that may be used for the mounting of one such source, denoted as L.

In one or more embodiments substrate 10, whatever the shape thereof, may include:

- a base layer 12 of an electrically insulating material, such as a polymer material as polyethylenterephthalate (PET), and
- a contact layer of electrically conductive material, e.g. copper, which is applied (via known techniques which therefore do not require a detailed description herein) onto base layer 12.

In the Figures there is shown an area of the contact layer destined to mounting one light radiation source L, having opposed (anode and cathode) terminals T1 and T2.

In one or more embodiments, as exemplified herein, such terminals may be split into several portions (e.g. according the solution described in the Italian Patent Application TO2014A0005752). One or more embodiments may however omit such specific implementation details of terminals T1 and T2 of source L.

The representation in Figure 2 corresponds to an ideal plan view of substrate 10 having source L mounted thereon: terminals T1 and T2 are therefore shown partially in continuous lines (in the section projecting from the lower portion of the body or package of source L) and partially in dashed lines (in the section that is covered by the body or package of source L).

In one or more embodiments, source L may also comprise a thermal contact pad T3 (the profile whereof is shown in dashed lines in Figure 2) adapted to facilitate the dissipation of the heat generated by source L towards the metal material of the contact layer.

In the presently shown examples, the contact layer comprises two portions 141, 142 separated by an e.g. straight gap 143.

As can be seen in the view of Figure 2, light radiation source L may be mounted bridge-like across and above gap 143, with the anode and cathode terminals T1 and T2 which will be soldered to the first portion 141 and to the second portion 142 of the contact layer via a soldering process, e.g. the process known as reflow soldering.

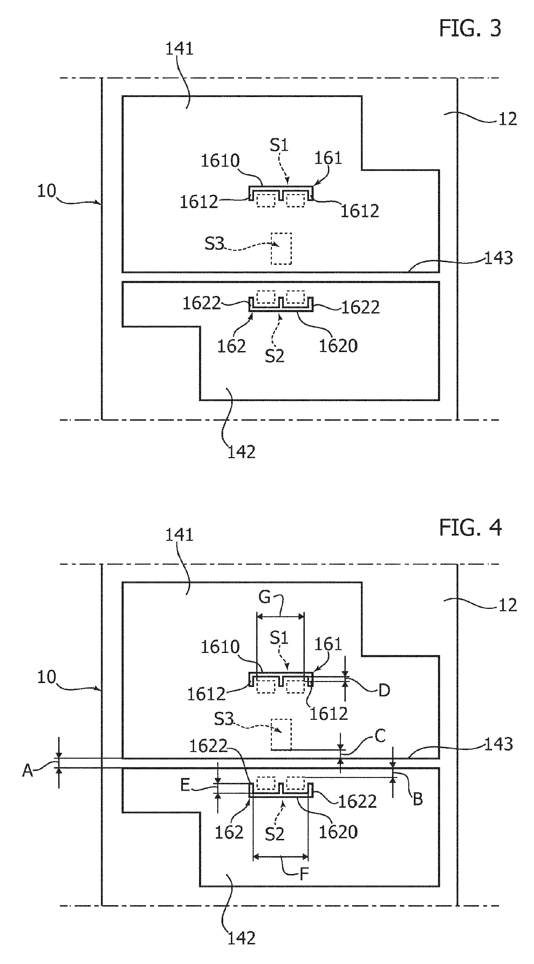

The soldering of terminals T1 and T2 may take place at respective soldering surfaces S1 and S2 (which in turn may optionally be split into two portions, in the same way as terminals T1 and T2), which are shown in dashed lines in Figures 3 and 4.

Such Figures show, again in dashed lines, the possibility of providing a further mounting surface S3, where it is possible to implement the contact between thermal pad T3 and the surface of the contact layer. In the presently shown example, which is solely exemplary, thermal pad T3 is located centrally with respect to source L, so as to bring about thermal contact, via portion 141, with source L largely extending above the first portion 141 of the contact layer, where soldering surface S1 and mounting surface S3 are located. It will be appreciated, however, that such choice is by no means mandatory: the mounting geometry of source L may be different, e.g. a mirror image of what shown herein.

Reference numbers 161 and 162 denote apertures or windows provided in the contact layer (respectively in first portion 141 and in second portion 142) so as to leave base layer 12 locally uncovered.

Such apertures or windows 161, 162 may be adapted to block the LED flow phenomenon previously described, which is connected to the soldering process (e.g. reflow soldering) and may prevent the consequent reduction of the electrical distance from the soldering surfaces on substrate 10, which may originate the drawbacks previously set forth in the introduction to the description.

In other words, apertures 161 and 162 act as blocking formations of the soldering flow, and correspond to areas wherein base layer 12 (e.g. a PET-based layer) is not covered by the soldering layer of an electrically conductive material (e.g. copper).

In one or more embodiments as exemplified herein, apertures or windows 161, 162 may be located externally with respect to soldering surfaces S1 and S2, i.e. on the side of soldering surfaces S1 and S2 opposed to gap 143.

In one or more embodiments, apertures 161, 162 may have a fork-like shape with two or more prongs: for example, in the presently shown instances, wherein terminals T1 and T2 are split into several portions corresponding to respective portions of soldering surfaces S1, S2, apertures 161, 162 have a shape which may be defined as a rake-like shape comprising three prongs, e.g.

with one prong entering the gap between the two portions of soldering area S1 or S2.

In one or more embodiments, as presently exemplified, fork-shaped apertures or windows 161, 162 may be shaped in such a way as to "envelope", at least in part, soldering surfaces S1 and S2.

Whatever the specific implementation details, in one or more embodiments, fork-shaped apertures 161, 162 may have a web portion 1610, 1620 wherefrom the prongs of the fork-like shape may extend towards soldering surfaces S1 and S2, i.e., in the presently shown examples, towards gap 143 between both portions 141, 142.

In one or more embodiments, as presently exemplified, fork-shaped apertures or windows 161, 162 may have symmetrical shapes, having equally long prongs.

Figure 4 shows the geometry of Figure 3, highlighting various size features of one or more embodiments.

Specifically, Figure 4 highlights the following sizes:

- A: extension of gap 143 separating both portions 141 and 142 of the contact layer;
- B: distance of soldering surface S2 of terminal T2 to source L and gap 143 in portion 142,
- C: distance of soldering surface S3 of thermal pad T3 of source L to gap 143 of portion 141,
- D: distance of web portion 1610, 1620 of apertures 161 and 162 to soldering surfaces S1, S2;
- E: length (extension) of the prongs of apertures 161 and 162 (such length is referred to the "inner" side of web portion 1610, 1620), if all prongs are equally long (which however is not mandatory);
- F: width F of apertures 161, 162, measured as the distance between the adjacent inner sides of prongs 1612, 1622 of apertures 161, 162; if, as in the presently shown cases, apertures 161, 162 have a number of prongs higher than two, distance F is defined between the two prongs which are located more externally with respect to the aperture; and
- G: width of soldering surfaces S1, S2 of terminals T1 and T2 of light radiation source L, measured cross-wise of the alignment direction of fork-shaped apertures 161, 162; if, as in the presently shown examples, surfaces S1 and S2 are split into several portions, length G is defined as the overall width, including the separation gaps between said portions.

In one or more embodiments, as regards the value of previously identified sizes D and E, it is possible to take into account the following considerations, referring to the shrinkage factor ($\Delta s\%$) of the material of base layer 12:

if $B < C$,

$$B < D < \Delta s\% * A+B$$

if $B > C$

$$C < D < \Delta s\% * A+C.$$

In one or more embodiments, the geometry of formations 161 and 162 may be such as to prevent excessive movements of the LED during soldering, which may reduce the electrical distance, while ensuring that LED terminals do not reach beyond areas 161 and 162, which may tend to approach each other during thermal processes because of the thermal shrinkage, unchecked by metal surface, concerning gap A, reducing it according to the shrinkage factor $\Delta s\%$. If the terminals should reach beyond formations 161 and 162, a proper soldering joint might not be ensured, because of the presence of electrically insulating material (e.g. PET), which is not solderable, under the terminals to be soldered.

On the basis of such considerations, as regards the value of sizes E and F, in order to effectively limit flow in the x direction (i.e. the alignment direction of blocking formations 161 and 162), E may be chosen higher than D, i.e. with the length of prongs of apertures 161 and 162 being greater than the separation distance of the soldering surfaces 161, 162 to the web portions 1610, 1620 of apertures 161, 162, so that prongs 1612, 1622 "envelop", at least partly, such soldering surfaces S1, S2.

It is moreover possible to choose F > G, so that the separation distance between the (most) external prongs 1612, 1622 of apertures 161, 162 is greater than width G of soldering surfaces S1, S2.

In one or more embodiments (while taking into account the normal processing tolerances), the following sizes may be chosen:

- A = 0.35 mm
- B = C = 0.5 mm

which, in the presence of a shrinkage factor of $\Delta s\%$ = 1%, may lead to 5 < D < 0,5035 mm.

Of course, without prejudice to the basic principles, the implementation details and the embodiments may vary, even appreciably, with respect to what has been described herein by way of non-limiting example only, without departing from the extent of protection.

The extent of protection is defined by the annexed claims.

**Claims**

1. A substrate (10) for mounting electrically-powered light radiation sources (L), including:

- a base layer (12) of electrically-insulating material, and
- a contact layer (141, 142) of electrically conductive material over said base layer (12), said contact layer including a mounting area for an electrically- powered light radiation source (L) having opposed anode and cathode terminals (T1, T2), said mounting area including two portions (141, 142) with a gap (143) therebetween for mounting said light radiation source (L) bridge-like across said gap (143) with said anode and cathode terminals (T1, T2) soldered to respective soldering surfaces (S1, S2) in the one (141) and the other (142) of said two portions (141, 142) of the mounting area,

wherein said two portions (141, 142) include respective solder flow blocking formations including fork-shaped apertures (161, 162) in said contact layer (141, 142) leaving said base layer (12) uncovered; said fork-shaped apertures (161, 162) with a web portion (1610, 1620) and prongs (1612, 1622) extending from said web portion (1610, 1620) towards said respective soldering surfaces (S1, S2).

2. The substrate of claim 1, wherein said fork-shaped apertures (161, 162) include rake-like apertures.

3. The substrate of claim 1 or claim 2, wherein said soldering surfaces (S1, S2) have a width (G) across the alignment direction of said fork-shaped apertures (161, 162) and wherein said fork-shaped apertures (161, 162) have a distance (F) between end prongs (1612, 1622) of the fork-shape, with said distance (F) larger than said width (G).

4. The substrate of any of the previous claims, wherein said soldering surfaces (S1, S2) have a separation distance (D) to the web portion (1610, 1620) of said fork-shaped apertures (161, 162).

5. The substrate of claim 4, wherein said separation distance (D) is less than the length (E) of the prongs (1612, 1622) of said fork-shaped apertures (161, 162).

6. The substrate of any of the previous claims, wherein one (141) of said two portions (141, 142) of the mounting area includes a mounting surface (S3) for a thermal pad (T3) of said lighting source (L), wherein said thermal pad (T3) mounting surface (S3) has a separation distance (C) to said gap (143).

7. The substrate of claim 6, wherein said separation distance (C) of said thermal pad (T3) mounting surface (S3) to said gap (143) in one (141) of said two portions (141, 142) of the mounting area is substantially equal to a distance (B) of the terminal soldering surface (S2) to the gap (143) in the other (142) of said two portions (141, 142) of the mounting area.

8. The substrate of any of the previous claims, wherein said base layer (12) is flexible and/or includes polyethylenterephthalate (PET).

9. The substrate of any of the previous claims, wherein said contact layer (141, 142) includes copper.

10. A method of manufacturing a lighting device, including:

- providing a substrate according to any of claims 1 to 9,
- mounting on said substrate at least one electrically-powered light radiation source, preferably a LED source (L), having opposed anode and cathode terminals (T1, T2) with said light radiation source (L) mounted bridge-like across said gap (143) with said anode and cathode terminals (T1, T2) soldered to said respective soldering surfaces (S1, S2).

FIG. 1

FIG. 2

FIG. 3

FIG. 4

Europäisches
Patentamt

European
Patent Office

Office européen
des brevets

# EUROPEAN SEARCH REPORT

Application Number

EP 16 18 2516

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 102 281 710 A (WINTEK CORP; DONGGUAN MASSTOP LCD CO LTD) 14 December 2011 (2011-12-14) | 1-5,10 | INV. H05K1/11 H05K1/18 |
| Y | * description *; figure 6 | 6-9 | H05K3/34 |
| X | JP 2005 286099 A (HITACHI INT ELECTRIC INC) 13 October 2005 (2005-10-13) * abstract * * paragraph [0005] - paragraph [0011]; figures * | 1-5,10 | |
| Y | US 2014/264427 A1 (TISCHLER MICHAEL A [CA]) 18 September 2014 (2014-09-18) * paragraph [0026] * * paragraph [0059] - paragraph [0067]; figures * | 6-9 | |
| A | US 6 069 323 A (SLUPEK DARRELL J [US] ET AL) 30 May 2000 (2000-05-30) * column 3 - column 5; figures * | 1-10 | |

TECHNICAL FIELDS
SEARCHED      (IPC)

H05K

The present search report has been drawn up for all claims

| Place of search | Date of completion of the search | Examiner |
|---|---|---|
| The Hague | 23 December 2016 | Geoghegan, C |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

    ...........................................................................
& : member of the same patent family, corresponding
    document

EPO FORM 1503 03.82 (P04C01)

# EP 3 131 372 A1

## ANNEX TO THE EUROPEAN SEARCH REPORT
## ON EUROPEAN PATENT APPLICATION NO.

EP 16 18 2516

This annex lists the patent family members relating to the patent documents cited in the above-mentioned European search report.
The members are as contained in the European Patent Office EDP file on
The European Patent Office is in no way liable for these particulars which are merely given for the purpose of information.

23-12-2016

| Patent document cited in search report | | Publication date | Patent family member(s) | | Publication date |
|---|---|---|---|---|---|
| CN 102281710 | A | 14-12-2011 | CN | 102281710 A | 14-12-2011 |
| | | | TW | 201146096 A | 16-12-2011 |
| | | | US | 2011292625 A1 | 01-12-2011 |
| JP 2005286099 | A | 13-10-2005 | NONE | | |
| US 2014264427 | A1 | 18-09-2014 | US | 2014264427 A1 | 18-09-2014 |
| | | | US | 2015333239 A1 | 19-11-2015 |
| | | | US | 2016204324 A1 | 14-07-2016 |
| | | | WO | 2014140811 A2 | 18-09-2014 |
| US 6069323 | A | 30-05-2000 | NONE | | |

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- IT 20140005752 A